# EUROPEAN PATENT APPLICATION

(11) **EP 4 832 045 A1**
(43) Date of publication of application: **28.10.2026**
(21) Application number: 24907364.4
(22) Date of filing: 16.12.2024
(51) Int. Cl.: H01J 37/20

(54) **STAGE**

(30) Priority: 19.12.2023 JP 2023213591
(71) Applicant: Mel-Build Corporation, Fukuoka-shi, Fukuoka 819-0025 (JP)
(72) Inventor: MIYAZAKI, Hiroya, Fukuoka-shi, Fukuoka 819-0025 (JP)
(74) Representative: Studio Torta S.p.A.
(86) International application number: PCT/JP2024/044409
(87) International publication number: WO 2025/134979

(57) **Abstract**

The present invention aims to provide a stage capable of transporting specimens under vacuum or other conditions.

[Solution]

The stage of the present invention is characterized by having a specimen base for mounting a specimen, a shutter function capable of blocking the atmosphere between the inside and outside of the stage, and a sealing portion. Furthermore, in a preferred embodiment of the stage of the present invention, it is further characterized by having a first valve capable of automatic exhaust. Furthermore, in a preferred embodiment of the stage of the present invention, it is further characterized by having a second valve whose degree of opening and closing can be adjusted.

## Description

### Technical Field

The present invention relates to a stage, and more particularly to a stage capable of transporting objects under vacuum or the like.

### Background Art

In recent years, high-resolution analysis using electron microscopes such as transmission electron microscopes (TEM) and scanning transmission electron microscopes (STEM) has advanced, with demands for high-resolution analysis ranging from the nano-order to the pico-order. Recently, "in-situ observation," which involves cooling (or heating, applying electric fields, magnetic fields, or rotating) a specimen while observing it within the electron microscope, has attracted attention. In particular, specimen cooling is considered effective in reducing damage to the specimen caused by the electron beam, and specimen cooling from this perspective is also being explored.

Furthermore, although SEM has lower magnification than TEM, it has fewer limitations on the size of the observed specimen, allowing for the observation of larger specimens. It is also easier to use than TEM, making observation and analysis easier. As a result, electron microscope manufacturers are developing products that can observe a variety of objects.

For example, a specimen processing device using a scanning electron microscope is known, which includes a cooling stage in which a specimen from which water has been sublimated and a manipulator extending over the cooling stage to cut out the necessary components of the specimen under observation by the scanning electron microscope, are placed in the specimen chamber of the scanning electron microscope (Patent Literature 1).

### Prior art literature

### Patent literature

Patent literature 1 :JP-A-S62-85840

### Summary of Invention

### Problems to be resolved by the invention

Given this need for cooling, conventional technologies, including the aforementioned Patent literature 1, only use the existing method of attaching the specimen to the upper surface of the specimen base of the existing cooling stage, and cooling is limited to the underside of the specimen.

Furthermore, conventional technology enables specimen observation by transferring it from an external vacuum to an SEM stage cooled with liquid nitrogen. That is, a method is employed in which a cartridge containing the specimen is inserted into the SEM using a rod or similar device. However, because this transfer is done from outside the electron microscope, it is physically impossible to bring electrical wiring and other components into the vacuum portion. For this reason, many researchers are eagerly awaiting an SEM stage that can observe the specimen while simultaneously cooling it and supplying power.

Therefore, the present invention aims to provide a stage that can be used for transfer under vacuum or other conditions.

### Means of solving the problems

In order to achieve the above objective, the inventors diligently studied the mechanism of the stage and, as a result, came to discover the present invention.

In other words, a stage of the present invention is characterized by having a specimen base for mounting a specimen, a shutter function capable of blocking the atmosphere between the inside and outside of the stage, and a sealing portion.

Furthermore, in a preferred embodiment of the stage of the present invention, it is further characterized by having a first valve capable of automatic exhaust.

Furthermore, in a preferred embodiment of the stage of the present invention, it is further characterized by having a second valve whose degree of opening and closing can be adjusted.

Furthermore, in a preferred embodiment of the stage of the present invention, it is further characterized by having a motor capable of opening and closing the shutter of the shutter function.

Furthermore, in a preferred embodiment of the stage of the present invention, it is further characterized by having a feedthrough portion.

Furthermore, in a preferred embodiment of the stage of the present invention, it is further characterized by having an electrode portion.

Furthermore, in a preferred embodiment of the stage of the present invention, it is characterized in that the specimen base is equipped with an attachment mounting device.

Furthermore, in a preferred embodiment of the stage of the present invention, it is further characterized by having a cooling portion.

Furthermore, in a preferred embodiment of the stage of the present invention, it is characterized by having a thermoelectric element installed in close proximity to the cooling portion.

Furthermore, in a preferred embodiment of the stage of the present invention, it is characterized in that the attachment mounting device is a screw hole or a clamp.

Furthermore, in a preferred embodiment of the stage of the present invention, it is characterized in that the thermoelectric element is a thermoelectric element utilizing an effect selected from at least one of the Peltier effect or the Thomson effect.

Furthermore, in a preferred embodiment of the stage of the present invention, it is characterized in that the heat dissipation side of the thermoelectric element and the cooling portion are in contact.

Furthermore, in a preferred embodiment of the stage of the present invention, it is characterized in that the cooling portion consists of at least one of a solid refrigerant, a liquid refrigerant, or a gaseous refrigerant.

Furthermore, in a preferred embodiment of the stage of the present invention, it is characterized in that the specimen base and the thermoelectric element are in contact.

### Effect of Invention

The stage of the present invention offers the advantageous effect of enabling transfer under conditions such as vacuum and Ar. Furthermore, according to another embodiment of the stage of the present invention, electrodes and the like can also be arranged, offering the advantageous effect of enabling observation of the object while, for example, electricity is flowing through a battery.

### Brief description of the drawings

[Figure 1]

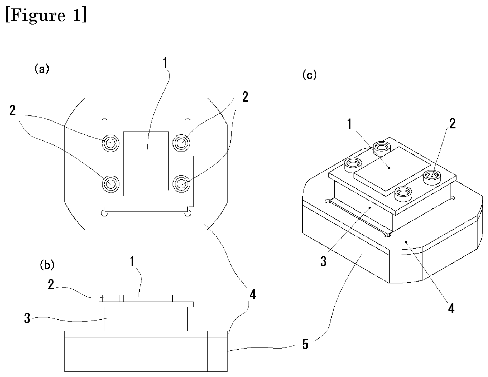

   FIG. 1 shows a conceptual diagram of the specimen base portion of the stage in one embodiment of the present invention. Figure 1(a) shows a top view of the specimen base portion of the stage in one embodiment of the present invention, Figure 1(b) shows a side view of the specimen base portion of the stage, and Figure 1(c) shows a perspective view of the specimen base portion of the stage, respectively.
[Figure 2]

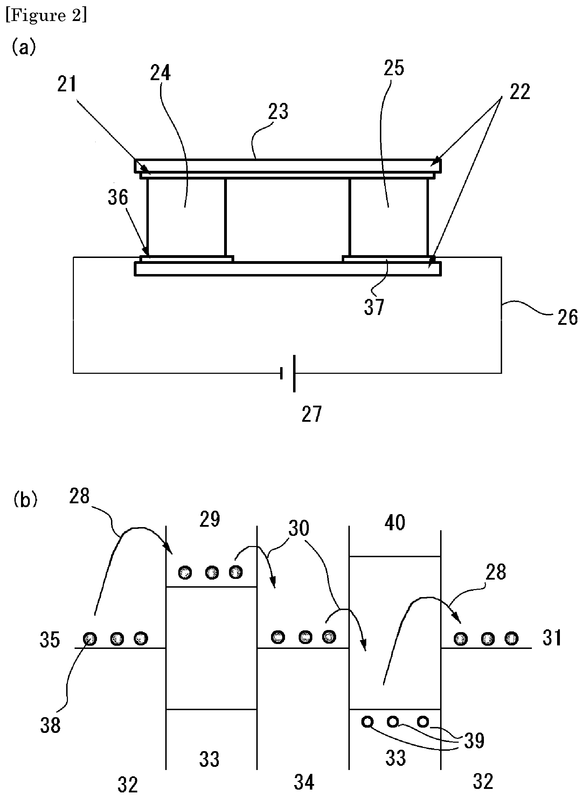

   FIG. 2 shows one embodiment of a thermoelectric element applicable to the present invention. Figure 2(a) shows a cross-sectional view of a Peltier element, and Figure 2(b) shows a schematic diagram of the principle of the Peltier element.
[Figure 3]

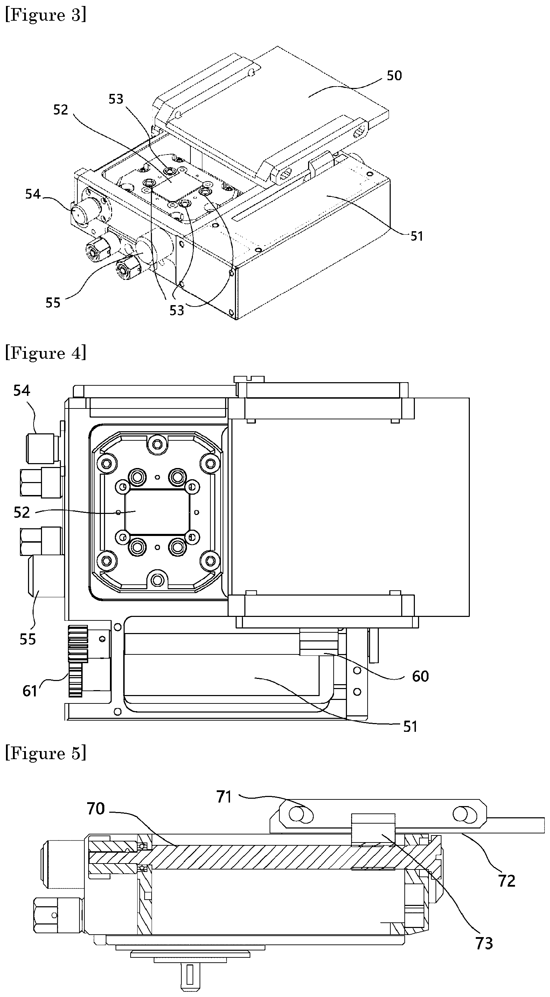

   FIG. 3 is a perspective view of a stage with a shutter function in one embodiment of the present invention.
[Figure 4]
   FIG. 4 is a top view of a stage with a shutter function in one embodiment of the present invention.
[Figure 5]
   FIG. 5 is a side cross-sectional view of a stage with a shutter function in one embodiment of the present invention.
[Figure 6]

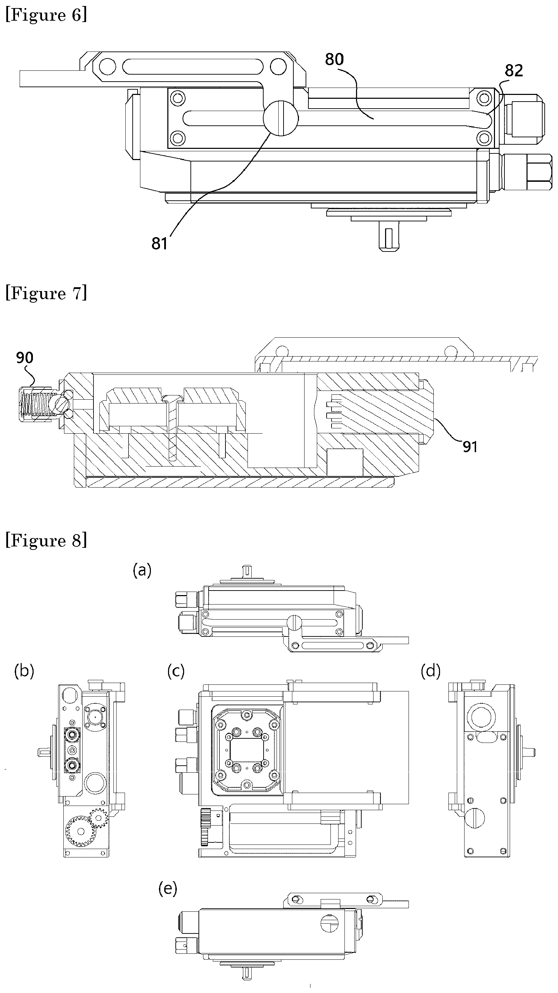

   FIG. 6 is a side view of a stage with a shutter function in one embodiment of the present invention.
[Figure 7]
   FIG. 7 is a side cross-sectional view of a stage with a shutter function in one embodiment of the present invention.
[Figure 8]
   FIG. 8 is a five-view drawing of a stage with a shutter function according to one embodiment of the present invention. Figures 8(a) and (e) are side views of the stage with a shutter function according to one embodiment of the present invention. Figure 8(c) is a top view of the stage with a shutter function according to one embodiment of the present invention. Figure 8(b) is a front view of the stage with a shutter function according to one embodiment of the present invention. Figure 8(d) is a rear view of the stage with a shutter function according to one embodiment of the present invention.
[Figure 9]

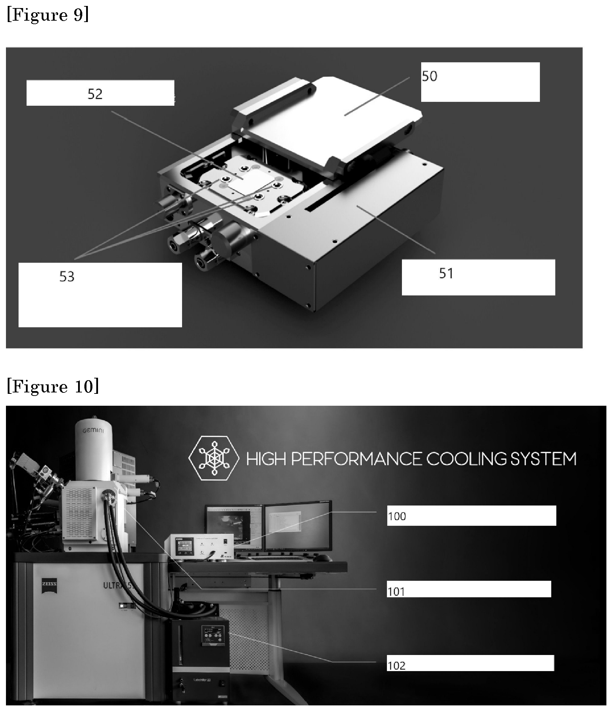

   FIG. 9 is a perspective view of a stage with a shutter function in one embodiment of the present invention.
[Figure 10]
   FIG. 10 shows an example of a cooling SEM stage system in one embodiment of the present invention.

### Mode for Carrying Out the Invention

The stage of the present invention is characterized by having a specimen base for mounting a specimen, a shutter function capable of blocking the atmosphere between the inside and outside of the stage, and a sealing portion. In the present invention, the specimen base for mounting the specimen is not particularly limited in shape, structure, etc., as long as it is capable of mounting a specimen to be observed in an electron microscope. Furthermore, the present invention has a shutter function capable of blocking the atmosphere between the inside and outside of the stage. By providing this shutter function, it is possible to create a structure in which electrodes can also be placed, provided that the structure is capable of independent vacuum transfer, and it becomes possible to observe while electricity is flowing through the battery. For example, in the invention, the glove box can be filled with Ar after being evacuated to remove moisture and other contaminants. The specimen is placed inside the glove box, and after being sealed with a vacuum transfer shutter with a cooling function under Ar gas filling or vacuum conditions using the shutter function, the stage can be transferred to the SEM under vacuum or Ar conditions.

Furthermore, in the present invention, the sealing portion is not particularly limited as long as it can block the atmosphere between the inside and outside of the stage during transport under vacuum or the like. As long as it can block the atmosphere between the inside of the stage (specimen placement side) and the outside, the sealing portion may be provided on the stage side, on the shutter side, on one side or both sides.

Furthermore, in a preferred embodiment of the stage of the present invention, it is further characterized by having a first valve capable of automatic exhaust. For example, in a glove box, Ar gas can be filled and brought to the SEM, and the SEM can be vacuumed and the lid opened to achieve non-exposure to the atmosphere. However, if the shutter is opened suddenly, a large amount of argon may flow into the SEM, potentially causing the SEM to shut down. Therefore, by having a first valve capable of automatic exhaust, it is possible to mitigate the inflow. For example, by providing a non-return valve (check valve) as the first valve capable of automatic exhaust, the valve can release the differential pressure generated between the SEM and the stage chamber, making it possible to more safely vacuum the chamber or the SEM, etc.

Furthermore, in a preferred embodiment of the stage of the present invention, it is further characterized by having a second valve whose degree of opening and closing can be adjusted. By having a second valve whose degree of opening and closing can be adjusted, it becomes possible to slowly replace the vacuum with an Ar atmosphere or the like. For example, when transferring from the SEM to the glove box, the chamber of the stage is under vacuum, so the second valve whose degree of opening and closing can be adjusted can be used as an opening and closing valve to slowly replace the vacuum with argon in the glove box.

Furthermore, in a preferred embodiment of the stage of the present invention, it is further characterized by having a motor capable of opening and closing the shutter of the shutter function. The motor allows for smooth opening and closing of the shutter. The motor may directly operate the shutter, or, as will be described later, it may be opened and closed via, for example, gears. It is also possible to remotely operate the shutter with a motor drive.

Furthermore, in a preferred embodiment of the stage of the present invention, it is further characterized by having a feedthrough portion. As described above, conventional air-free electron microscopes are designed so that voltage cannot be applied because the specimen is placed on a cartridge and transported under vacuum from outside the electron microscope. To conduct electricity, a feedthrough is required to isolate the wiring from the vacuum. A feedthrough can be defined as a vacuum component attached to a vacuum wall that separates the vacuum from the atmosphere in order to transport and control electrical signals, physical motion, fluids, etc., inside a device that maintains a vacuum state. In the present invention, the feedthrough portion makes it possible, for example, to observe the specimen while applying voltage.

Furthermore, in a preferred embodiment of the stage of the present invention, it is further characterized by having an electrode portion. One or more electrode portions can be set. In the present invention, it is possible to attach an electrode shape desired by the user. This makes it possible to customize the way electricity is applied as desired by the researcher.

Furthermore, in a preferred embodiment of the stage of the present invention, it is characterized in that the specimen base is equipped with an attachment mounting device. That is, in the embodiment equipped with the attachment mounting device of the present invention, attachments can be easily attached and removed, and various attachments can be exchanged. The position in which the attachment mounting device is provided may be the same as the position of the electrodes described above, or it may be provided separately from the electrodes.

Furthermore, in a preferred embodiment of the stage of the present invention, it is further characterized by having a cooling portion. In the present invention, the cooling portion (unit) is not particularly limited in shape, structure, etc., as long as it is capable of cooling the specimen observed in the electron microscope. The specimen base portion can be cooled by the cooling portion or a Peltier element, but the parts other than the cooling portion are at a higher temperature. Therefore, if an attachment is connected and fixed to a part other than the area around the cooling portion (outside the cooling system), the attachment will be heated by heat from outside the cooling system. In this case, when the attachment warms up, heat is transferred to the specimen, causing the specimen, which has been cooled, to warm up, thus reducing the cooling effect. In an embodiment of the present invention in which the specimen base is equipped with an attachment mounting device, the attachment is located within the cooling system via the attachment mounting device, and consequently, it becomes possible to cool the specimen with minimal heat loss.

Furthermore, in a preferred embodiment of the stage of the present invention, it is characterized in that the attachment mounting device is a screw hole or a clamp, from the viewpoint of being able to firmly and reproducibly fix the attachment. In the present invention, since an attachment mounting device, such as a screw part, is provided, it becomes easy to change the attachment according to the purpose. Double-sided tape and adhesives are difficult to remove once the attachment is fixed and are not intended for reuse. In addition, the degree of thermal contact between the attachment and the specimen base changes each time it is changed, and it is difficult to control the posture of the attachment. In contrast, in the present invention, since the attachment can be changed reproducibly by attaching the attachment mounting device, it has the advantage of being able to flexibly respond to various applications.

Furthermore, while the attachment is not particularly limited as long as it can be attached, in a preferred embodiment of the stage of the present invention, the attachment is characterized by being at least one selected from a FIB grid holding attachment, a specimen fixing attachment, and an electrical supply attachment. In addition to the FIB grid holding attachment and the top surface fixing attachment, if the specimen is observed with the clamping direction oriented sideways, a temperature gradient can be created from the clamped portion toward the free end portion by cooling from the clamped portion. In the present invention, an attachment capable of providing such a temperature gradient can also be installed. Attachments that have a cold trap function to prevent contamination by placing a cooling member near the top surface of the specimen can also be considered.

Here, when the term "cold trap" is used, it can be understood as a device that cools and captures trace amounts of floating substances (gases: hydrocarbons, etc.) in a vacuum. That is, if there is gas in the vacuum, it is expected that it will be struck against the specimen when irradiated with an electron beam and accumulate on top of the specimen. In the present invention, when a cooling member is placed near the top surface, it is possible to create a mechanism that surrounds the area near the specimen with a cooled metal member (cooling member) in a range that does not obstruct electron beam irradiation, etc., thereby creating a region with a locally high vacuum. This makes it possible to construct a mechanism that cools and condenses the released gas in order to collect it, and in turn, makes it possible to prevent gas present in the vacuum within the electron microscope from adhering to the specimen.

Furthermore, when considering applications that involve not only cooling but also simultaneously applying current to the specimen, the influence of external temperature can be reduced by fixing electrodes and specimen fixing clamps using (via) attachment devices such as screw parts, or by fixing and applying current to the specimen on an extended platform fixed with an attachment device. Such attachments can also be attached in the present invention.

Furthermore, in a preferred embodiment of the stage of the present invention, the attachment mounting device is characterized by being made of a thermally conductive material. As examples of materials with high thermal conductivity, mention may be made of copper and copper alloys, aluminum and aluminum alloys, silver, and gold. 39In the present invention, for example, an attachment mounting device, such as screw holes, is integrally arranged on the specimen base portion of the stage for cooling a specimen in a scanning electron microscope (SEM), making it possible to attach attachments of shapes and forms according to the purpose. As a result, the attachment is also incorporated into the cooling system, and the influence of external heat is reduced, enabling various cooling methods to be realized.

Furthermore, in a preferred embodiment of the stage of the present invention, it is characterized in that the cooling portion consists of at least one of a solid refrigerant, a liquid refrigerant, or a gaseous refrigerant. In the cooling portion, the refrigerant can be appropriately set depending on the application and is not particularly limited. From the viewpoint of versatility, a liquid can be mentioned as a preferred medium. If a liquid (such as water) is used, the temperature can be adjusted using a general-purpose device (cooling chiller), while it can also be a source of vibration because it is a fluid. Liquid nitrogen or liquid helium can also be used as the liquid.

Furthermore, in the present invention, from the viewpoint that it is possible to reduce the influence of vibrations due to water flow and pulsation compared to water cooling to almost zero, the cooling portion may be a solid refrigerant. That is, in the present invention, it is possible to cool the heat dissipation surface of a Peltier element or the like with a solid refrigerant such as dry ice. This makes it possible to reduce the influence of vibrations due to water flow and pulsation compared to water cooling to almost zero. Also, in the case of a solid, the difficulty in adjusting the temperature of the cooling portion can be addressed by using a thermoelectric element as described later.

On the other hand, when the cooling gas is flowed at a minute flow rate, the effect of vibration is small, so these can also be used in the present invention. The cooling gas can be, for example, one obtained by gasifying liquid nitrogen. This makes it possible to cool the specimen well. In the present invention, the cooling gas is not limited to liquid nitrogen. If the gas is simply passed weakly through the heat dissipation surface, the effect of vibration is almost negligible and it is considered to be practical. Therefore, in the present invention, as described above, even when a solid refrigerant is actually used as the cooling portion, it is sufficient to apply the cold air with a gap rather than pressing it against the heat dissipation surface. Similarly, when using liquid nitrogen gas, observation is possible without being affected by vibration by passing the cooling gas through the heat dissipation surface. The difficulty in adjusting the temperature of the cooling portion can be controlled using a thermoelectric element as described later.

Furthermore, in a preferred embodiment of the stage of the present invention, it is characterized by having a thermoelectric element installed in close proximity to the cooling portion. In the present invention, the placement position of the thermoelectric element is not particularly limited as long as it is installed in close proximity to the cooling portion (section). The thermoelectric element makes it possible to efficiently set the temperature required for the specimen, that is, to control the temperature. In the embodiment using a thermoelectric element, the cooling and heating response is good and the effects of thermal drift can be minimized, and because the cooling and heating response is good, precise temperature control is possible. In the embodiment using a thermoelectric element, cooling and heating can be achieved with a single element simply by reversing the direction of current flow, and at the same time, because the cooling and heating response is fast, it is easy to change to a predetermined temperature. Furthermore, precise temperature control is possible by adjusting the output of the input power, so precise temperature control is possible and the effects of thermal drift can be minimized.

Furthermore, in a preferred embodiment of the stage of the present invention, it is characterized in that the heat dissipation side of the thermoelectric element and the cooling portion are in contact. That is, in the present invention, the thermoelectric element only needs to be positioned close to the cooling portion. For example, it may be a structure in which the cooling portion, such as a solid refrigerant, is pressed against the heat dissipation side (heat dissipation surface side), or a structure in which cold air is applied with a gap. When applying cold air, natural convection or forced convection using a fan may be used, but if forced convection generates vibration, natural convection is preferable, depending on the degree of forced convection. Even in the case of natural convection, since the solid refrigerant has a sufficiently low temperature, there is a large temperature gradient between the heat dissipation surface side and the cold air of the cooling portion such as the solid refrigerant, so it is considered that sufficient heat transfer occurs and the heat dissipation surface can be appropriately cooled. Note that heat dissipation treatment by forced convection is more effective than natural convection, and by water cooling is more effective than air cooling.

Furthermore, in a preferred embodiment of the stage of the present invention, it is characterized in that the thermoelectric element is a thermoelectric element utilizing an effect selected from at least one of the Peltier effect or the Thomson effect. The Peltier effect (also called the Peltier effect) is an effect that converts electrical energy into thermal energy, and is a phenomenon in which a temperature difference is generated at both ends when an electric current is passed through two dissimilar metals (or semiconductors) connected at both ends. It is particularly called a Peltier element and is used for cooling precision equipment and wine cellars. The Thomson effect, on the other hand, is an effect that occurs when an electric current is passed through a uniform metal (or dissimilar metals) with a temperature gradient, resulting in the generation of heat other than Joule heat (heat absorption when the current is reversed). Both can generate or absorb heat.

In addition, a heat dissipation member may be installed between the thermoelectric element and the cooling portion, etc., from the viewpoint of efficient heat dissipation from the thermoelectric element.

Furthermore, in a preferred embodiment of the stage of the present invention, the thermoelectric element is characterized by being a Peltier element, from the viewpoint of having good cooling and heating response and minimizing the effects of thermal drift. A Peltier element is also called a Peltier element (thermo-module), and this is a general term for elements that utilize the Peltier effect. The structure that is currently mainstream and is considered to have the best performance is called the "π type," which has the structure shown in Figure 2. By passing an electric current through the PN junction using a P-type semiconductor and an N-type semiconductor, heat can be dissipated between P and N and absorbed between N and P.

The principle is as follows. Figure 2 shows one embodiment of a thermoelectric element applicable to the present invention. Figure 2(a) shows a cross-sectional view of a Peltier element, and Figure 2(b) shows a schematic diagram of the principle of the Peltier element. In Figure 2(a), 21 is the hot side metal (mainly Cu), 22 is the ceramic substrate (mainly alumina), 23 is the heat dissipation surface, 24 is the N-type semiconductor, 25 is the P-type semiconductor, 26 is the electric wire, 27 is the power supply, 28 is the heat absorption, 29 is the conduction band of the N-type semiconductor, 30 is the heat dissipation, 31 is the positive side, 32 is the heat absorption side, 33 is the valence band, 34 is the heat dissipation side, 35 is the negative side, 36 is the cold side metal (mainly Cu), 37 is the cold side metal (mainly Cu), 38 is the electron, 39 is the hole, and 40 is the conduction band of the P-type semiconductor.

In Figure 2(a), the negative electrode is connected to the metal 36 on the N-type semiconductor 24 side. Therefore, the voltage pushes electrons from the conduction band of the metal 36 to the conduction band 29 of the N-type semiconductor 24. At this time, because there is an energy gap between the conduction band of the metal 36 and the conduction band 29 of the N-type semiconductor 24, the electrons absorb thermal energy from the metal 36, and as a result cool the metal 36. Subsequently, the electrons flow and fall from the conduction band 29 of the N-type semiconductor 24 to the conduction band of the metal 21. Due to the energy gap between the two bands, the electrons release thermal energy. In this way, the hot side metal 21 is heated. Furthermore, the incoming electrons fall from the conduction band of the metal 21 into the holes 39 that have flowed through the P-type semiconductor 25, releasing thermal energy and heating the metal 21 on the hot side. Within the P-type semiconductor 25, the voltage produces holes 39, which flow from the cold side 37 to the hot side 21. The electrons generated at that time are pushed up to the conduction band of the metal on the cold side by the voltage, absorbing thermal energy corresponding to their energy gap and cooling the metal 37 on the cold side. In this way, heat is transferred from the cold side to the hot side of the Peltier module by the flow of current. In addition to the thermal energy transferred by current, there is also thermal energy transferred by heat conduction, but since the thermal energy carried by heat conduction flows in the opposite direction, reducing the amount of heat conduction improves the performance of the Peltier module.

In other words, removing the thermal energy from the hot side as quickly as possible with a heat sink or the like will allow the Peltier module to perform well. Simply put, electrons carry (or absorb) heat.

While semiconductor materials are not particularly limited and can all be applied, Bi-Te semiconductors are considered to have the best performance and are the mainstream.

Regarding the performance of a Peltier element, generally speaking, its performance can be considered in terms of how much temperature difference ΔT can be created relative to the temperature Th when the temperature of the heat dissipation side is kept constant. For example, for Th = 75, 50, 25 (°C), ΔT = 93, 85, 75. If the heat dissipation surface is simply cooled to, for example, the temperature of liquid nitrogen (-196°C), the heat absorption surface is thought to exceed minus 200 degrees Celsius, but in reality, due to the properties of the material, ΔT is assumed to be 10°C near liquid nitrogen. This is because the lower the temperature, the less heat is available to excite electrons, thus reducing the Peltier cooling capacity. Also, the lower the temperature, the greater the electrical resistance of the semiconductor part, resulting in self-heating due to the current, which reduces the overall cooling capacity.

Furthermore, in a preferred embodiment of the present invention, the heat-dissipating side of the thermoelectric element and the cooling portion are in contact, from the viewpoint that it is possible to set a lower temperature by cooling the heat-dissipating side of the thermoelectric element. In the following embodiments, the case of cooling is mainly described, but in the present invention, heating is also possible with the thermoelectric element. During heating, the lower surface of the thermoelectric element cools down, so it is necessary to heat the cooling portion before use (to process at a higher temperature than the lower surface). In this case, it can function as a heating portion rather than a cooling portion.

In the case of heating, the phenomenon is simply reversed compared to the case of cooling, but the practicality will also change depending on the shape of the thermoelectric element (whether it is multi-stage or not), such as a Peltier element. When aiming for extremely low temperatures, a multi-stage thermoelectric element, such as a Peltier element, can be used. In this case, a pyramidal structure can be created where the area of the heat-absorbing surface (upper stage) is small and increases towards the heat-dissipating surface. This structure is used because, generally, a larger area absorbs more heat, so the heat absorbed by the smaller upper stage is dissipated by the larger lower stage. When using it for heating purposes by reversing the polarity of the current, it is not so simple, as heat from the larger lower stage tends to flow rapidly into the smaller upper stage. If the upper stage cannot absorb all of this heat, heat accumulates in the middle stage, and its temperature tends to be higher than the upper stage. Therefore, even when using Peltier elements for heating, the temperature is thought to be around +100°C (the temperature at which the solder at the junction does not degrade). A Peltier element creates a heat-absorbing surface and a heat-dissipating surface through the movement of electrons, and in principle, it is possible to precisely control the temperature from near room temperature to the negative temperature range by controlling the amount of current supplied to the Peltier element. These effects enable stable, high-resolution observation.

Furthermore, in a preferred embodiment of the stage of the present invention, from the viewpoint of cooling after the specimen base, it is characterized in that the specimen base and the thermoelectric element are in contact.

### Example

Hereafter, a stage in one embodiment of the present invention will be described with reference to the drawings, but the present invention is not limited to these embodiments. Moreover, it goes without saying that the present invention can be modified as appropriate without departing from the spirit of the invention.

Figure 1 shows a conceptual diagram of the specimen base portion of the stage in one embodiment of the present invention. Figure 1(a) shows a top view of the specimen base portion of the stage in one embodiment of the present invention, Figure 1(b) shows a side view of the specimen base portion of the stage, and Figure 1(c) shows a perspective view of the specimen base portion of the stage, respectively. In Figure 1, 1 represents the specimen base, 2 represents an attachment mounting device or electrode, 3 represents a thermoelectric element (if a thermoelectric element is required), 4 represents a heat dissipation member, and 5 represents a cooling portion, respectively.

Referring to the figure, the roles of each component and the connections between each component in the specimen base of the stage in one embodiment of the present invention are explained below. First, there is the stage body, and in Figure 1, it is a configuration having a cooling portion 5. However, in the case of heating as described above, the lower surface of the thermoelectric element cools down during heating, so it is necessary to heat the cooling portion before use (to process at a higher temperature than the lower surface). In this case, it can be used as a heating portion (unit) rather than a cooling portion. Also, in this example, a thermoelectric element 3 is used, but in a configuration where the thermoelectric element 3 is not used, the thermoelectric element 3 can be omitted. In this example, since this configuration uses a thermoelectric element 3, a heat dissipation member 4 may be provided as needed, as shown in the figure. Furthermore, in this example, the attachment mounting device 2 is specifically a screw hole, but as mentioned above, it may be a clamp or the like, and is not particularly limited as long as the attachment can be attached and removed. The attachment mounting device 2 is preferably made of a thermally conductive material. This makes it possible to further avoid heat loss. If the attachment mounting device is not used, it can be an electrode 2.

Moreover, the Peltier element and the specimen base can be directly above or extended with a lateral offset, as long as they are in thermal contact. Furthermore, although the clamp is shown vertically in the figure, the specimen may be clamped horizontally. One characteristic feature is that the attachment mounting holes or electrodes are integrated with the specimen base. The mounting holes or electrodes may be integrally machined, or the screw holes may be manufactured separately and then press-fitted or bonded later.

Furthermore, although not shown in the figure, a FIB grid may be installed as an attachment. In this case, the FIB grid holding attachment can be attached to the FIB grid holding base using copper screws or the like. It is also possible to fix the FIB specimen holding base to the specimen base as a cooling attachment. The FIB mesh can be clamped so that it stands vertically in the center of the FIB grid's divisions. This reduces damage from electron beams and ion beams through the cooling effect. If the base is made slightly larger, it is also possible to clamp and observe normal specimens. A structure that allows for horizontal clamping of the specimen is also possible.

Although not shown in the figures, it is also possible to fix the specimen from above using an attachment. The top surface of the observation specimen can be fixed by a specimen fixing attachment installed at the top. By fixing the specimen from above using an attachment, and by constructing the attachment and other components from a thermally conductive material, it is possible to cool the specimen from above as well. In the present invention, since attachments etc. can be changed with good reproducibility by attaching an attachment mounting device, it has the advantage of being able to flexibly respond to various applications.

Next, Figure 3 is a figure showing a perspective view of a stage with a shutter function in one embodiment of the present invention. In Figure 3, 50 is the shutter, 51 is the motor, 52 is the specimen base (with a cooling portion below, if present), 53 is the attachment mounting device or electrode, 54 is the first valve, and 55 is the second valve, respectively. In Figure 3, the shutter 50 is shown in the open state, showing an example of the inside of the stage. The shutter can be opened and closed, and although not shown, when the shutter is closed, the inside of the stage can be made into a vacuum or Ar atmosphere, allowing for the transfer of vacuum or other materials. The motor 51 can open and close the shutter 50, as will be described later. 52 can function as the specimen base, and by extension, as a cooling or heating portion for the specimen. In this example, cooling is performed using a Peltier element. Using Peltier cooling enables overwhelmingly high throughput. Cooling with liquid nitrogen requires a significant amount of time before and after observation: 1 hour to cool the temperature, 1 hour for the temperature to stabilize, and 1 hour to return to room temperature after observation. However, because Peltier cooling simply involves passing an electric current, it can cool very quickly, reaching -100 degrees Celsius in 3 minutes and room temperature in 1 minute, dramatically increasing the speed of research. The reason why liquid nitrogen was previously used is that conventional Peltier cooling stages could only cool down to -50 degrees Celsius. At -50 degrees Celsius, damage from electron beams and focused ion beams cannot be mitigated, and cooling to -80 to -100 degrees Celsius is necessary. Therefore, even if one wanted to use Peltier cooling, the only option was to use a liquid nitrogen type. Surprisingly, however, this invention makes it possible to achieve -100 degrees Celsius with the Peltier cooling method.

53 is an attachment mounting device or electrode. If it is an attachment mounting device, the contents of Figure 1 described above can be cited as an example. The attachment mounting device and electrode can be used together, but the electrode alone may also be used. The electrodes can be fitted with the electrode shape desired by the user, and their shape, arrangement, etc., are not limited. In Figure 3, four electrodes are shown, but there can be one or more electrodes. The way electricity is applied can be customized according to the researcher's requirements.

Furthermore, 54 is the first valve, which, for example, enables automatic exhaust in a vacuum. In the glove box, Ar gas, etc., is filled and taken to the SEM, and the SEM is made into a vacuum and the lid is opened to achieve non-exposure to the atmosphere. However, if the shutter is opened suddenly, a large amount of argon will flow into the SEM, and there is a risk that the SEM will shut down. Therefore, by providing an automatically exhaustable valve, for example, a non-return valve, a differential pressure is created between the SEM and the stage chamber, and this differential pressure causes the valve to open, making it possible to create a vacuum inside the chamber.

55 is a second valve, which can be, for example, a valve whose degree of opening and closing can be adjusted. Conversely to the above, when the stage is transferred from the SEM to the glove box, the second valve 55 functions as an on/off valve that more slowly replaces the vacuum with argon in the glove box, since the stage chamber is under vacuum.

Next, Figure 4 is a figure showing a top view of a stage with a shutter function in one embodiment of the present invention. In Figure 4, 50 is the shutter, 51 is the motor, 52 is the specimen base (with a cooling portion below, if present), 54 is the first valve, 55 is the second valve, 60 is the shutter opening and closing screw, and 61 is the gear for connecting the opening and closing lid, respectively. The shutter 50, motor 51, specimen base (with a cooling portion below, if present) 52, first valve 54, and second valve 55 can be described in the above explanation. 60 is a shutter opening/closing screw. When the motor 51 rotates, the shutter opening/closing screw 60 rotates, causing the shutter to move forward to seal the inside of the stage. In this example, the rotation of the motor is used to control the opening and closing movement of the shutter using an opening/closing cover connecting gear 61.

Next, Figure 5 is a figure showing a side cross-sectional view of a stage with a shutter function in one embodiment of the present invention. In Figure 5, 70 is a rotating shaft, 71 is a seal auxiliary part, 72 is a shutter, and 73 is a shutter opening/closing screw, respectively. In this example, the rotating shaft 70 has threads cut into it, and the shutter opening/closing screw 73 has threads that interlock (mesh) with these threads. When the rotating shaft 70 rotates due to the motor, the rotational movement is transmitted to the shutter opening/closing screw 73, and in accordance with the rotation, the shutter moves to the right in Figure 5. A sealing part, such as an O-ring, is located on the back side of the shutter 72, and when the shutter closes, it is possible to block the atmosphere between the inside and outside of the stage. The sealing auxiliary part 71 in this example is a tapered part installed on the side of the shutter. When the shutter closes, the guide pin bites into the tapered part 71, allowing the lid (stage lid, shutter) to be pressed against the base (stage body). This makes it possible to further enhance the sealing effect of the O-ring. Note that the seal is provided on the shutter side, but it may also be provided on the stage side.

Next, Figure 6 is a figure showing a side view of a stage with a shutter function in one embodiment of the present invention. In Figure 6, 80 indicates a guide rail, 81 indicates a guide pin, and 82 indicates a tapered part, respectively. In accordance with the opening and closing movement of the shutter, the guide pin 81 can move along the guide rail. The tapered portion of 82 is tapered, and in the final stage of closing the shutter, the guide pin 81 applies a downward force to the lid (upper part of the stage, shutter), holding the lid in place so that the O-ring can effectively seal the surface. The guide pins 81 on both sides and the tapered portion 82 firmly press the entire lid against the sealing surface. This structure allows for the provision of a compact atmosphere isolation function.

Next, Figure 7 is a figure showing a lateral cross-sectional view of a stage with a shutter function according to one embodiment of the present invention. In Figure 7, 90 indicates the first valve, and 91 indicates the feed-through portion, respectively. Regarding the first valve 90, it can be referred to the description above. In the present invention, the position of the field-through portion is not particularly limited. The field-through portion makes it possible, for example, to observe the specimen while applying voltage.

Next, Figure 8 is a figure showing a five-view drawing of a stage with a shutter function in one embodiment of the present invention. Figures 8(a) and (e) are figures showing side views of the stage with a shutter function in one embodiment of the present invention. Figure 8(c) is a figure showing a top view of the stage with a shutter function in one embodiment of the present invention. Figure 8(b) is a figure showing a front view of the stage with a shutter function in one embodiment of the present invention. Figure 8(d) is a figure showing a rear view of the stage with a shutter function in one embodiment of the present invention.

Next, Figure 9 is a figure showing a perspective view of a stage with a shutter function in one embodiment of the present invention. In Figure 9, 50 is the shutter, 51 is the motor, 52 is the specimen base (with a cooling portion below, if present), and 53 is the attachment mounting device or electrode, respectively. These can be described in reference to Figure 3.

Next, Figure 10 is a diagram showing an example of a cooling SEM stage system in one embodiment of the present invention. In Figure 10, 100 is the temperature control controller, 101 is the feedthrough portion, and 102 is the refrigerant supply device, respectively. The temperature control controller 100 has a function that controls the temperature inside the stage. The feedthrough 101 is a component for passing electricity, temperature measurement, and cooling water into a vacuum. The refrigerant supply device 102 is a device that can deliver refrigerant without vibration.

As described above, according to the stage of the present invention, by providing the stage with a shutter function, it is possible to create a structure that allows for independent vacuum transfer, and electrodes can also be arranged, thereby achieving the advantageous effect of enabling observation while electricity is flowing through the battery. In particular, it has been found that speedy experiments can be performed in the embodiment using Peltier cooling.

### Industrial applicability

The stage can be transferred under vacuum, etc., and in-situ observation can be performed even under cooling, making it applicable in a wide range of technical fields.

### Explanation of symbols

1 Specimen base
2 Attachment mounting device or electrode
3 Thermoelectric element (if a thermoelectric element is required)
4 Heat dissipation member
5 Cooling portion
21 Hot side metal (mainly Cu)
22 Ceramic substrate (mainly alumina)
23 Heat dissipation surface
24 N-type semiconductor
25 P-type semiconductor
26 Electric wire
27 Power supply
28. Heat absorption
29. Conduction band of N-type semiconductors
30. Heat dissipation
31. Positive side
32. Heat absorption side
33. Valence band
34. Heat dissipation side
35. Negative side
36. Cold side metal (mainly Cu)
37. Cold side metal (mainly Cu)
38 Electrons
39 Holes
40 Conduction band of P-type semiconductor
50 Shutter
51 Motor
52 Specimen base (cooling portion below (if present))
53 Attachment mounting device or electrode
54 First valve
55 Second valve
60 Screw for opening and closing shutter
61 Gear for connecting opening and closing lid
70 Rotating shaft
71 Seal auxiliary part
72 Shutter
73 Screw for opening and closing shutter
80 Guide rail
81 Guide pin
82 Tapered section
90 First valve
91 Feedthrough portion (section)
100 Temperature control controller
101 Feedthrough
102 Refrigerant supply device

## Claims

1. A stage **characterized by** having a specimen base for mounting a specimen, a shutter function capable of blocking the atmosphere between the inside and outside of the stage, and a sealing portion.

2. The stage according to claim 1, further **characterized by** having a first valve capable of automatic exhaust.

3. The stage according to claim 1 or 2, further **characterized by** having a second valve whose degree of opening and closing can be adjusted.

4. The stage according to any one of claims 1 to 3, further **characterized by** having a motor capable of opening and closing the shutter of the shutter function.

5. The stage according to any one of claims 1 to 4, further **characterized by** having a feedthrough portion.

6. The stage according to any one of claims 1 to 5, further **characterized by** having an electrode portion.

7. The stage according to any one of claims 1 to 5, **characterized in that** the specimen base is equipped with an attachment mounting device.

8. The stage according to any one of claims 1 to 6, further **characterized by** having a cooling portion.

9. The stage according to claim 7, **characterized by** having a thermoelectric element installed in close proximity to the cooling portion.

10. The stage according to any one of claims 6 to 8, **characterized in that** the attachment mounting device is a screw hole or a clamp.

11. The stage according to claim 9 or 10, **characterized in that** the thermoelectric element is a thermoelectric element utilizing an effect selected from at least one of the Peltier effect or the Thomson effect.

12. The stage according to any one of claims 9 to 11, **characterized in that** the heat dissipation side of the thermoelectric element and the cooling portion are in contact.

13. The stage according to any one of claims 8 to 12, **characterized in that** the cooling portion consists of at least one of a solid refrigerant, a liquid refrigerant, or a gaseous refrigerant.

14. The stage according to any one of claims 9 to 13, **characterized in that** the specimen base and the thermoelectric element are in contact.
